(19) Europäisches Patentamt
European Patent Office
Office européen des brevets

(11) Publication number: **0 172 267**
**B1**

(12) **EUROPEAN PATENT SPECIFICATION**

(45) Date of publication of patent specification: **01.07.87**

(51) Int. Cl.$^4$: **C 25 D 3/60**

(21) Application number: **84109981.5**

(22) Date of filing: **22.08.84**

# (54) Tin-lead alloy plating bath.

(43) Date of publication of application:
**26.02.86 Bulletin 86/09**

(45) Publication of the grant of the patent:
**01.07.87 Bulletin 87/27**

(84) Designated Contracting States:
**DE FR GB IT NL**

(56) References cited:
**FR-A-2 534 279**
**US-A-4 132 610**

(73) Proprietor: **Hyogo Prefecture**
**10-1, Shimoyamatedori 5-chome**
**Chuo-ku Kobe-shi Hyogo-ken (JP)**
(73) Proprietor: **Daiwa Fine Chemicals Co., Ltd.**
**3-18, Tsukamotodori 3-chome Hyogo-ku**
**Kobe-shi Hyogo-ken (JP)**
(73) Proprietor: **Ishihara Chemical Co., Ltd.**
**5-26, Nishi Yanagihara-cho Hyogo-ku**
**Kobe-shi Hyogo-ken (JP)**

(72) Inventor: **Obata, Keigo**
**81-1, Koriki-cho**
**Himeji-shi Hyogo-ken (JP)**
Inventor: **Dohi, Nobuyasu**
**1-4, Tsukimiyamahonmachi 1-chome**
**Suma-ku Kobe-shi Hyogo-ken (JP)**
Inventor: **Okuhama, Yoshiaki**
**No. 502, Okamoto Excel 5-17, Okamoto 6-chome**
**Higashi Nada-ku Kobe-shi Hyogo-ken (JP)**
Inventor: **Masaki, Seishi**
**16-5, Nishiyama-cho 4-chome**
**Nagata-ku Kobe-shi Hyogo-ken (JP)**
Inventor: **Okada, Yukiyoshi**
**1-1, Izumidai 4-chome**
**Kita-ku Kobe-shi Hyogo-ken (JP)**
Inventor: **Yoshida, Tadashi**
**4-2, Tsukushigaoka 4-chome**
**Kita-ku Kobe-shi Hyogo-ken (JP)**

**EP 0 172 267 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

(74) Representative: **Schwan, Gerhard, Dipl.-Ing.**
**Elfenstrasse 32**
**D-8000 München 83 (DE)**

**Description**

BACKGROUND OF THE INVENTION

This invention relates to a sulfonic acid bath for tin-lead alloy plating capable of giving a deposit of stabilized tin-lead alloy composition.

For tin-lead alloy plating the use of commonly employed borofluoride baths has been subject to varied limitations due to the necessity of disposing of the resulting fluorine-containing wastewater. From this viewpoint tin-lead alloy plating baths using organic sulfonic acids of relatively low toxicity have recently been proposed. For example, Japanese Patent Application Nos. 176365/1982 and 55190/1983 disclosed that light-grayish, uniform, fine-grained electroplated coatings of tin-lead alloy could be obtained by adding to an organic sulfonic acid bath a nonionic surface active agent, such as an adduct of styrenated phenol with an alkylene oxide (e.g., polyoxyethylene tristyrylphenyl ether, POETSPE) and an additive, such as a certain sulfanilic acid [e.g., N-(3-hydroxybutylidene)-p-sulfanilic acid, HBPSA] and/or a triazine [e.g., 2,4-diamino-6-{2'-alkylamidazolyl(1')}ethyl-1,3,5-triazine, DAAIMET].

Tin-lead alloy (generally known as solder) plating is used extensively in light electric and electronic industries for joining metallic surfaces of components. For applications wherein occurrence of whiskers is undesirable, solder deposits containing from a few % to 20% of lead are applied. For applications wherein resistance to corrosion is required, solder deposits containing from 70% to 80% of lead are applied. Further, in fabricating printed-circuit boards, 60/40 utectic solder deposits are applied as an etching resist.

Thus, since deposits having various compositions are required for tin-lead alloy plating according to their applications, it is ideal to always obtain deposits having a constant composition even if the current density changes from low to high.

For example, the printed-circuit boards with the tin-lead alloy are usually subjected to fusing, a treatment for removing overhangs and enhancing the solderability. The treatment, however, will give uneven, rough treated surfaces if the deposit produced by electroplating on the surface regions of the printed-circuit board is dissimilar in composition to that formed in through-hole plating with consequent difference in melting point between the two deposits. Therefore, in plating printed-circuit boards with a tin-lead alloy, it is necessary to assure deposition of a uniform composition throughout the surface regions and holes of the boards.

The plating baths described in the above-mentioned patent applications produce tin-lead alloy plates with fairly improved throwing power and fusing property. Under low current density conditions, however, they tend to increase the lead contents in the resulting deposits of tin-lead alloy, rendering it impossible to form plated coatings of the desired Sn/Pb ratio. In order to ensure high reliability required of printed-circuit boards, it is imperative that the Sn/Pb ratio in the deposits be stable, the deposits be improved in the fusing property and in stability against heat to be applied in subsequent process steps, and the plating bath be easy to control.

In view of the foregoing, we have investigated various addition agents. As a result, it has now been found that a certain group of guanamine compounds give tin-lead alloy plated coatings having a constant Sn/Pb ratio, under not only low current density conditions but even high current density conditions, the Sn/Pb ratio being substantially the same as that of the plating bath. It has also been found that these guanamine compounds yield plates possessing good throwing power, fusing property, and heat resistance without the addition of any such nonionic surface active agent or additive as referred to in the cited patent applications.

BRIEF SUMMARY OF THE INVENTION

Accordingly, it is an object of the present invention to provide a tin-lead alloy plating bath capable of giving a deposit of a constant Sn/Pb ratio under high as well as low current density conditions.

In accomplishing these objects, there has been provided in accordance with the present invention a tin-lead alloy plating bath as set forth in claim 1, followed by claims 2—5 concerning particular embodiments of the invention.

Guanamine compounds which are employed in the invention have the general formula

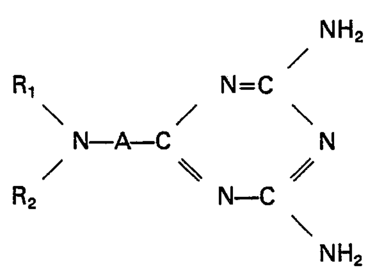

wherein $R_1$ and $R_2$, which may be the same or different, represent each a hydrogen atom, $C_{1-18}$ straight- or branched-chain alkyl radical, $C_{1-18}$ straight- or branched-chain alkoxy-lower alkyl radical, or a $C_{3-7}$ cycloalkyl radical, or $R_1$ and $R_2$ may combine to form a carbon cycle or hetero cycle, and A represents a lower alkylene radical.

## BRIEF DESCRIPTION OF THE DRAWINGS

FIG. 1 is a graphic representation of the relations between varied current densities for tin-lead alloy plating using a guanamine compound and the lead contents in the resulting deposits; and

FIG. 2 is a graphic representation of the surface condition after fusing of the tin-lead alloy plate in an embodiment of the invention.

## DETAILED DESCRIPTION

Desirable guanamine compounds for the purposes of the invention include those of the above-mentioned general formula in which either $R_1$ or $R_2$ represents a hydrogen atom and the other represents a $C_{5-14}$ alkyl (e.g., pentyl, hexyl, heptyl, octyl, nonyl, decyl, or dodecyl), $C_{5-14}$ alkoxy-ethyl or alkoxy-propyl (e.g., pentyloxy-, hexyloxy-, peptyloxy-, octyloxy-, 2-ethylhexyloxy-, or decyloxy-ethyl or -propyl), or cyclohexyl radical, and those in which $R_1$ and $R_2$ combine to form a piperidine, morpholine, or piperazine cycle. A desirable lower alkylene radical is ethylene or propylene radical.

Examples of usable guanamine compounds are mentioned in Table 1 to be given later.

TABLE 1

| No. | Compound | Abridged | Chemical formula |
|---|---|---|---|
| 1 | β-N-Dodecylamino-propioguanamine | β—N—DPG | 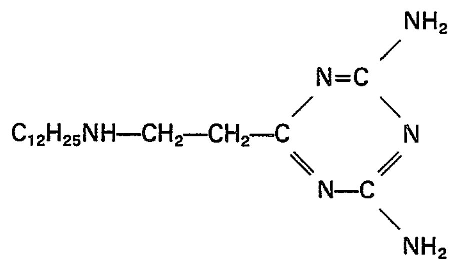 |
| 2 | β-N-Hexylamino-propioguanamine | β—N—HPG | 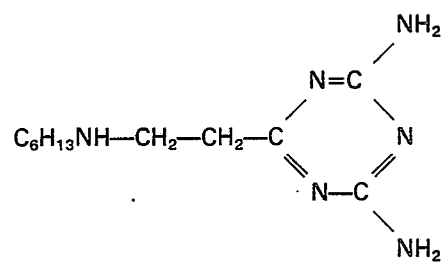 |
| 3 | Piperidine-propioguanamine | PPA | 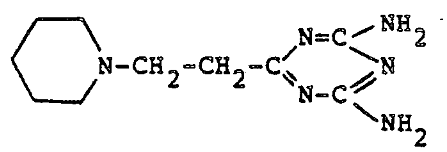 |
| 4 | Cyclohexylamino-propioguanamine | CHAA | 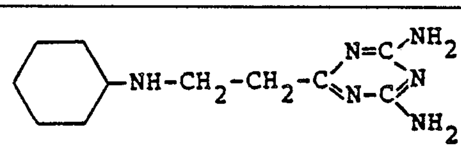 |
| 5 | Morpholine-propioguanamine | MMA | 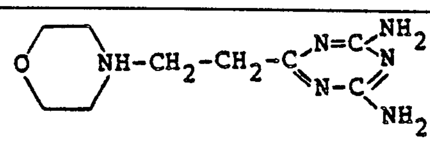 |
| 6 | β-N-(2-Ethylhexyl-oxypropylamino)-propioguanamine | $C_2C_6OPAA$ | 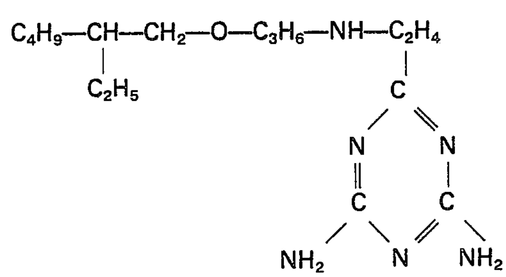 |

TABLE 1 (continued)

| No. | Compound | Abridged | Chemical formula |
|---|---|---|---|
| 7 | β-N-(Lauryloxy-propylamino)-propioguanamine | $C_{12}OPAA$ | 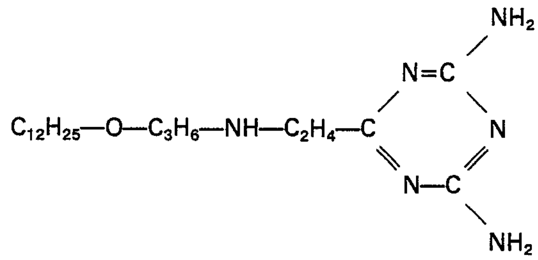 |

Among particularly desirable ones are those in which either $R_1$ or $R_2$ of the general formula represents a $C_{1-18}$ alkoxy-lower alkyl radical, e.g., β-N-(2-ethylhexyloxypropylamino)propioguanamine.

A guanamine compound in accordance with the invention is added in an amount of 0.01 to 30 g, preferably 0.1 to 10 g, per liter of the plating solution.

The principal plating solution according to the invention consists basically of at least one of alkanesulfonic and alkanolsulfonic acids and a tin salt and a lead salt of such a sulfonic acid.

The alkane- or alkanolsulfonic acid employed has the general formula

$$R—SO_3H$$

wherein R is a $C_{1-12}$ alkyl radical, or

$$HO—R—SO_3H$$

wherein R is a $C_{1-12}$ alkylene radical and OH may be located in any desired position.

Examples of alkanesulfonic acids are methane-, ethane-, propane-, 2-propane-, butane-, 2-butane-, pentane-, hexane-, decane-, and dodecanesulfonic acids. These alkanesulfonic acids may be used singly or as a mixture of two or more.

Examples of alkanolsulfonic acids are isethionic acid and 2-hydroxyethane-1-, 2-hydroxypropane-1-, 1-hydroxypropane-2-, 3-hydroxypropane-1-, 2-hydroxybutane-1-, 4-hydroxybutane-1-, 2-hydroxypentane-1-, 2-hydroxyhexane-1-, 2-hydroxydecane-1-, and 2-hydroxydodecane-1-sulfonic acids. These hydroxyl-containing alkanesulfonic acids may be employed alone or in a combination of two or more.

The total concentration of tin and lead salts is, in terms of the respective metallic elements, in the range of 0.5—200 g/l, preferably in the range of 10—100 g/l. The concentration of the free alkanesulfonic or alkanolsulfonic acid present in the plating bath is 30—400 g/l, preferably 70—150 g/l.

In accordance with the invention, a plated coating having substantially the same Sn/Pb ratio as that of the plating bath can be obtained under a broad range of current densities including low current density conditions.

The tin-lead alloy plating bath of the invention may contain various additives commonly used in such plating bath, such as surface active agents and leveling agents.

The concentrations of the individual constituents of the plating bath according to the present invention may be optionally chosen depending on whether the plating is performed by the barrel, rack, high-speed continuous, or through-hole plating technique. The plating bath of the invention is capable of producing uniform, dense plated coatings at a wide range of current densities.

The present invention will now be illustrated by the following examples showing typical plating bath compositions and operating conditions. It should be noted, however, that the invention is not limited thereto but may be variously embodied with free modifications of the bath composition and plating conditions to realize the afore-described objects.

## Example 1

A) A bath of the composition comprising

| | | |
|---|---|---|
| stannous 2-hydroxypropanesulfonate (as a bivalent tin) | 12 | g/l |
| lead 2-hydroxypropanesulfonate (as a bivalent lead) | 8 | " |
| free methanesulfonic acid | 100 | " |
| $C_2C_6OPAA$* | 2 | " |

* β-N-(2-Ethylhexyl oxypropylamino)-propioguanamine was prepared and used for plating a copper wire.

The plating was performed by galvanostatic electrolysis with 600 coulombs at a predetermined current density, using a copper wire, 2 mm dia. and 250 mm long, as the cathode and moving it at a rate of 2 m/min. The individual deposits thus obtained were dissolved in 6N HCl and their lead contents (in percent by weight) were determined by atomic absorption analysis. The results are shown in FIG. 1.

B) For comparative purposes, a bath of the composition comprising

| | | |
|---|---|---|
| Stannous 2-hydroxypropanesulfonate (as a bivalent tin) | 12 | g/l |
| Lead 2-hydroxypropanesulfonate (as a bivalent lead) | 8 | ,, |
| Free methanesulfonic acid | 100 | ,, |
| POETSPE* | 5 | ,, |
| HBPSA** | 0.1 | ,, |
| DAAIMET** | 0.7 | ,, |

* polyoxyethylene tristyrylphenyl ether
** N-(3-hydroxybutylidene)-p-sulfanilic acid
*** 2,4-diamino-6-{2'-alkylimidazolyl(1')}ethyl-1,3,5-triazine was prepared and used for plating in the same manner as described in the above A). The deposits thus obtained were dissolved in 6N HCl and their lead contents (in percent by weight) were determined by atomic absorption analysis. The results are shown in FIG. 1.

Example 2

The test specimens tin-lead alloy plated from the bath of A) of Example 1 were subjected to infrared fusing at varied temperatures. The surface conditions treated at the different temperatures were evaluated. The plating was carried out under a relatively low current density condition (0.25 $A/dm^2$) to a plate thickness of 10 μm. A constant heating time of 3 seconds was used for fusing at each predetermined temperature.

For the fusing tests a near-infrared-ray planar heater, automatic SCR power controller, and temperature controller were used. The plated test piece was set on a copper sheet for temperature control connected to an iron-constantan thermocouple, and was irradiated with infrared rays from the direction perpendicular to the piece.

The test results are shown in FIG. 2.

As a criterion of the fusing property, complete fusing at a relatively low temperature is desired. The addition of the stabilizer, whichever was employed, made it possible for the bath to yield a completely fusible surface as compared with the surface from the nonstabilized bath of the fundamental composition.

Example 3

The following two baths were prepared:

A) a bath of the composition comprising

| | | |
|---|---|---|
| stannous methanesulfonate (as a bivalent tin) | 54 | g/l |
| lead methanesulfonate (as a bivalent lead) | 6 | ,, |
| free methanesulfonic acid | 120 | ,, |
| $C_2C_6$OPAA | 5 | ,, |

B) A bath for comparative purposes of the composition comprising

| | | |
|---|---|---|
| stannous methanesulfonate (as a bivalent tin) | 54 | g/l |
| lead methanesulfonate (as a bivalent lead) | 6 | ,, |
| free methanesulfonic acid | 120 | ,, |

| | | |
|---|---|---|
| POETSPE | 5 | g/l |
| HBPSA | 0.1 | „ |
| DAAIMET | 0.7 | „ |

These baths were used for plating in the same manner as described in A) of Example 1. The deposits thus obtained were dissolved in 6N HCl and their lead contents (in percent by weight) were determined by atomic absorption analysis. The results are shown in the following table.

| | Lead content in deposit (wt %) | |
|---|---|---|
| Bath | Current | density |
| | 0.5 A/dm$^2$ | 20 A/dm$^2$ |
| A) | 9.8 | 10.2 |
| B) | 23.1 | 16.5 |

**Claims**

1. A tin-lead alloy plating bath based on a principal plating bath comprising an alkanesulfonic and/or alkanolsulfonic acid and both bivalent tin and lead salts thereof, characterized by the addition of a guanamine compound having the general formula

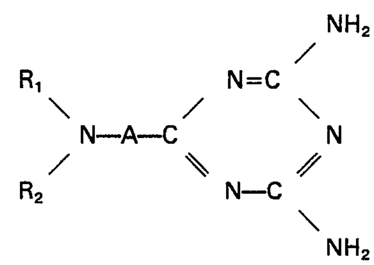

wherein $R_1$ and $R_2$, which may be the same or different, represent each a hydrogen atom, $C_{1-18}$ straight- or branched-chain alkyl radical, $C_{1-18}$ straight- or branched-chain alkoxy-lower alkyl radical, or a $C_{3-7}$ cycloalkyl radical, or $R_1$ and $R_2$ may combine to form a carbon cyclo or hetero cycle, and A represents a lower alkylene radical.

2. A plating bath according to claim 1 characterized in that said guanamine compound is used at a concentration of 0.01 to 30 g per liter of the plating bath.

3. A plating bath according to claim 1 characterized in that said alkane- or alkanolsulfonic acid has, respectively, the general formula

$$R—SO_3H$$

wherein R is a $C_{1-12}$ alkyl radical, or

$$HO—R—SO_3H$$

wherein R is a $C_{1-12}$ alkylene radical and OH may be located in any desired position.

4. A plating bath according to claim 1 characterized in that said tin and lead salts of an alkanesulfonic or alkanolsulfonic acid are used at a concentration, in terms of the respective metallic elements, of 0.5 to 200 g per liter of the bath.

5. A plating bath according to claim 1 characterized in that the free alkanesulfonic or alkanolsulfonic acid is used at a concentration of 30 to 400 g per liter of the bath.

**Patentansprüche**

1. Zinn/Blei-Legierungs-Plattierbad basierend auf einem Hauptplattierbad, das eine Alkansulfonsäure oder Alkanolsulfonsäure und zweiwertige Zinn- und Bleisalze derselben aufweist, gekennzeichnet durch den Zusatz einer Guanaminverbindung der allgemeinen Formel

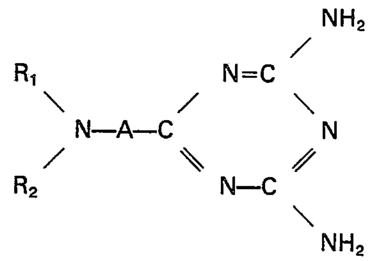

wobei $R_1$ und $R_2$ gleich oder verschieden sein können und jeweils ein Wasserstoffatom, ein geradkettiges oder verzweigtkettiges $C_{1-18}$-Alkylradikal, ein geradkettiges oder verzweigtkettiges $C_{1-18}$-Alkoxy-niedriges Alkylradikal oder ein $C_{3-7}$-Cycloalkylradikal darstellen oder $R_1$ und $R_2$ vereinigt sein können, um eine carbozyklische oder heterozyklische Verbindung zu bilden, und A ein niedriges Alkylenradikal darstellt.

2. Plattierbad nach Anspruch 1, dadurch gekennzeichnet, daß die Guanaminverbindung in einer Konzentration von 0,01 bis 30 g pro Liter des Plattierbades verwendet ist.

3. Plattierbad nach Anspruch 1, dadurch gekennzeichnet, daß die Alkan-bzw. Alkanolsulfonsäure die allgemeine Formel

$$R—SO_3H$$

wobei R ein $C_{1-12}$-Alkylradikal, oder

$$HO—R—SO_3H$$

hat, wobei R ein $C_{1-12}$-Alkylenradikal ist und OH in jeder gewünschten Position stehen kann.

4. Plattierbad nach Anspruch 1, dadurch gekennzeichnet, daß die Zinn- und Bleisalze einer Alkansulfon- oder Alkanolsulfonsäure in einer Konzentration, ausgedrückt durch die betreffenden metallischen Elemente, von 0,5 bis 200 g pro Liter des Bades verwendet sind.

5. Plattierbad nach Anspruch 1, dadurch gekennzeichnet, daß die freie Alkansulfon- oder Alkanolsulfonsäure in einer Konzentration von 30 bis 400 g pro Liter des Bades verwendet ist.

**Revendications**

1. Bain de dépôt d'alliage étain-plomb basé sur un bain de dépôt principal comprenant un acide alcanesulfonique et/ou alcanolsulfonique, et les sels de ceux-ci à la fois avec le plomb et l'étain bivalents, caractérisé par l'addition d'un composé de type guanamine ayant la formule générale:

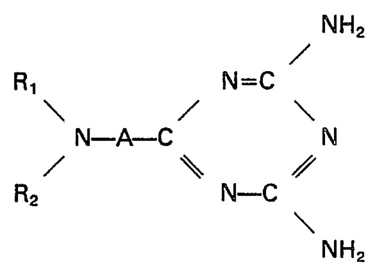

dans laquelle $R_1$ et $R_2$ qui peuvent etre identiques ou différents, représentent chacun un atome d'hydrogène, un groupe alkyle en $C_1$—$C_{18}$ à chaîne droite ou ramifiée, un groupe alkoxy en $C_1$—$C_{18}$ à chaîne droite ou ramifiée — alkyle inférieur, ou un groupe cycloalkyle en $C_3$—$C_7$, ou $R_1$ et $R_2$ peuvent être combinés pour former un cycle carboné ou un hétérocycle, et A représente un groupe alkylène inférieur.

2. Bain de dépôt suivant la revendication 1, caractérisé en ce que ledit composé de type guanamine est utilisé à une concentration de 0,01 à 30 g/litre du bain de dépôt.

3. Bain de dépòt suivant la revendication 1, caractérisé en ce que ledit acide alcane ou alcanolsulfonique, a respectivement la formule générale:

$$R—SO_3H$$

dans laquelle R est un groupe alkyle en $C_1$—$C_{12}$, ou

$$HO—R—SO_3H$$

dans laquelle R est un groupe alkylène en $C_1$—$C_{12}$ et le groupe OH peut être situé à une position quelconque requise.

4. Bain de dépôt suivant la revendication 1, caractérisé en ce que lesdits sels d'étain et de plomb d'acide alcanesulfonique ou alcanolsulfonique, sont utilisés à une concentration de 0,5 à 200 g/litre du bain, calculée sous la forme des éléments métalliques correspondants.

5. Bain de dépôt suivant la revendication 1, caractérisé en ce que l'acide alcanesulfonique ou alcanolsulfonique libre est utilisé à une concentration de 30 à 400 g/litre du bain.

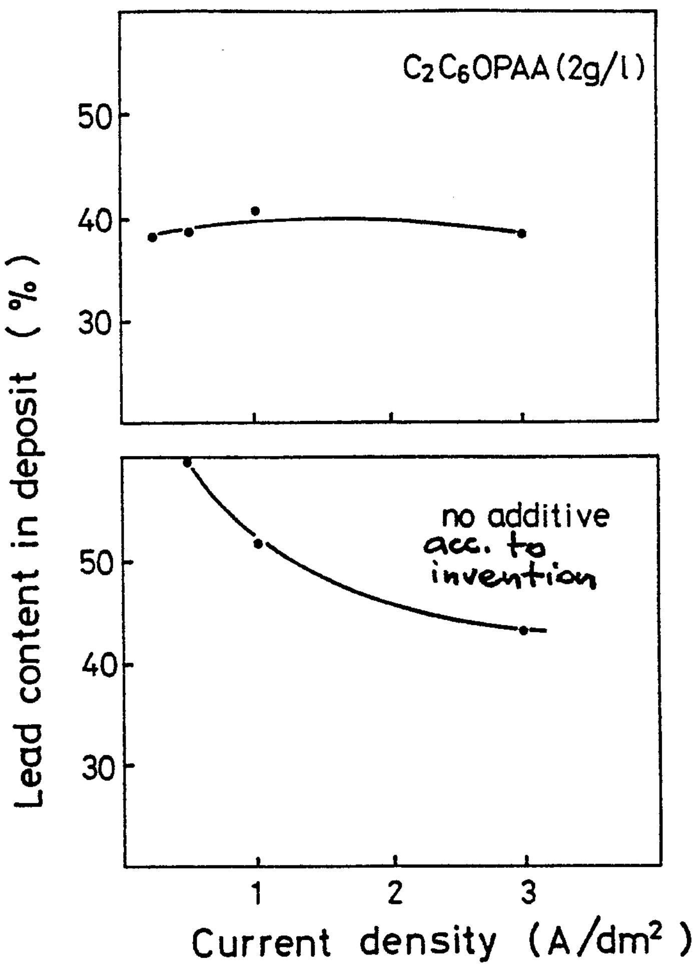
C2C6OPAA (2g/l)
50
40
30
no additive
acc. to invention
50
40
30
Lead content in deposit (%)
1
2
3
Current density (A/dm²)

Fig. 1

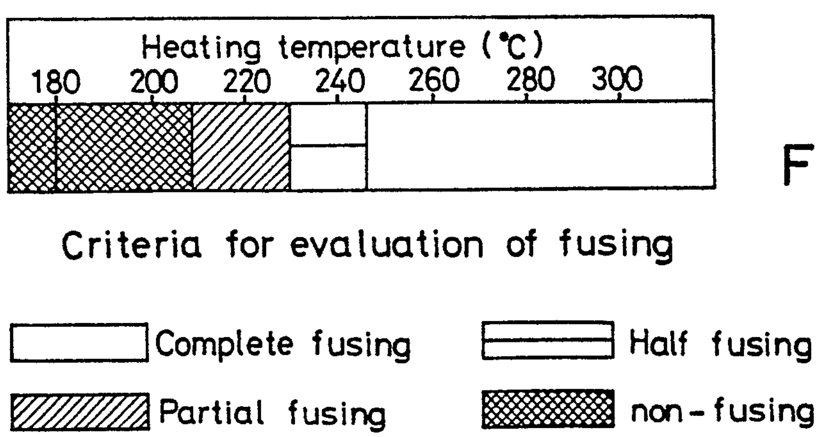
Heating temperature (°C)
180 200 220 240 260 280 300
Criteria for evaluation of fusing
Complete fusing
Half fusing
Partial fusing
non-fusing

Fig. 2